Europäisches Patentamt

European Patent Office

Office européen des brevets

(19)

(11) EP 0 725 407 A1

## (12) EUROPEAN PATENT APPLICATION

(43) Date of publication:
07.08.1996 Bulletin 1996/32

(51) Int Cl.⁶: H01F 17/00

(21) Application number: 96480007.2

(22) Date of filing: 23.01.1996

(84) Designated Contracting States:
DE FR GB

(30) Priority: 03.02.1995 US 383399

(71) Applicant: International Business Machines
Corporation
Armonk, N.Y. 10504 (US)

(72) Inventors:
• Nmh Hsieh, Chang-Ming
Fishkill, NY 12524 (US)
• Hsu, Louis Li-Chen
Fishkill, NY 12524 (US)

(74) Representative: Klein, Daniel Jacques Henri
Compagnie IBM France
Département de Propriété Intellectuelle
06610 La Gaude (FR)

### (54) Three-dimensional integrated circuit inductor

(57)    A three-dimensional inductor manufactured using standard integrated circuit fabrication techniques. A first set of conductive wires (10) is formed on a substrate. A magnetic core (40) is deposited next followed by a second set of conductive lines (70); each set likewise insulated from the magnetic core. A plurality of conductive vias (60), preferably formed around the periphery of the magnetic core link the first and the second set of conductive lines through the insulation, thereby forming a continuous electric path wrapped around the magnetic core. By expanding the number of sets of conductive lines and conductive vias, several windings around the core may be obtained, thereby forming a primary and secondary windings of a transformer.

FIG.2A

**Description**

<u>FIELD OF THE INVENTION</u>

The present invention relates to inductive structures, and more particularly, to an inductor for use in high frequency applications and which is manufactured using standard integrated circuit (IC) fabrication techniques.

<u>BACKGROUND OF THE INVENTION</u>

Inductive components play an important role in analog circuitry, especially in high frequency applications, such as high-pass filters, high-frequency filters, equalizers, and the like. High value inductors, i.e., in the range of nano-Henries (nH) to micro-Henries ($\mu$H) are oftentimes used as voltage controlled oscillators of phase-lock-loop circuits for frequency synthesizers. Such devices find wide application in tuners for FM broadcast, general aviation, maritime and land-mobile communications, etc. Foreseeably, devices of this type will also find their way in micro-machining applications, such as micro-motors and micro- generators. In view of the difficulty of integrating semiconductor inductors on a chip, most of these devices are implemented as discrete components, such as Motorola's Micro Metal Toroidal Core. Whereas discrete components offer a certain degree of flexibility to the design, generally, they add to the manufacturing cost and to the size of the packaging. The problem becomes unmanageable when many inductors are needed in the circuit.

The making of semiconductor integrated circuit inductors is known in the art. Design of such devices have been advanced for quite some time. By way of example, B. C. Felton, in the IBM describes a planar coupled inductor using intermeshed or concentric conductor coils sandwiched in between two layers of ferromagnetic material. Although a planar inductor can be obtained, it is highly unlikely that inductances can be achieved in the range of micro-Henries ($\mu$H) or milli-Henries (mH), which is required in today's high performance analog applications.

In a second example, in US-A-5 227 659 to Hubbard, an IC inductor is fabricated using standard CMOS techniques. The device is formed on a substrate by alternating conducting and insulating layers which are deposited and patterned such that each conducting layer forms one loop. The loops being connected between the insulating layers form the coil with their axis normal to the layers. By including a magnetic core, the inductance can be increased to values as high as 0.1 mH. The inductor thus disclosed is a multi-turn vertical coil with a magnetic core sitting vertically to the wafer surface. The process of building such an inductor requires an extra process step for each coil or turn, thereby making the construction of a device of this kind expensive and difficult.

In yet another example, in US-A 5 095 357 to Andoh et al., a semiconductor IC inductor having a planar spiral winding disposed on the surface of a substrate is described. The spiral is spaced from the substrate by a plurality of spaced apart electrically conductive posts having a staggered arrangement between adjacent windings of the spiral. Similar to the previous case, the magnetic core is placed vertically to the wafer surface. Whereas the process of building an inductor of this kind is simpler than Hubbard's invention, it still requires a much larger area to make an inductor with the same inductance.

<u>OBJECTS OF THE INVENTION</u>

Accordingly, is an object of the present invention to provide a three-dimensional IC inductor having an increased inductance and a reduced area and volume.

It is another object to provide a compact inductor having an inductance in a range spanning from $\mu$H to mH.

It is a further object to have a three-dimensional structure having a ferromagnetic core laying horizontally on the wafer surface which is built using the same conventional process as that used for metal interconnections.

It is yet another object to provide an inductor with coils that require few process steps and which does not necessitate having additional process steps for each coil.

It is still another object to provide an inductor which is essentially planar.

It is a more particular object to provide an inductor with high packing density using conventional semiconductor fabrication techniques.

It is yet a further object to provide an inductor which can be easily integrated with other devices such as transistors, resistors and capacitors, to form an integrated circuit on a wafer.

It is still a more particular object to provide an inductor having more than one coil circling around a common core to form a transformer.

<u>SUMMARY OF THE INVENTION</u>

According to the general object of the present invention, there is provided in a semiconductor IC, an inductor comprising: a first plurality of conductive lines on a substrate; a second plurality of conductive lines separated from the first plurality of conductive lines; a magnetic core between the first plurality of conductive lines and the second plurality of conductive lines; insulating material separating the first plurality of conductive lines and the second plurality of conductive lines from the magnetic core; and conducting vias extending through the insulating material and spaced from the magnetic core, connecting the first and second plurality of conductive lines, wherein the first and second plurality of conductive lines and the conducting vias are relatively positioned to form a contiguous conductive coil about the magnetic core.

## BRIEF DESCRIPTION OF THE DRAWINGS

The foregoing and other objects, features, and advantages of the present invention will be apparent from the more particular detailed description of the embodiments of the invention, as illustrated in the accompanying drawings, in which:

FIG. 1 depicts a perspective view of a prior art IC spiral inductor;

FIG. 2A is a perspective view of a preferred embodiment of an "L" shaped three-dimensional IC inductor, in accordance with the present invention;

FIG. 2B is a cross-section view of a three-dimensional IC inductor, according to the methods of the present invention, irrespective of its shape;

FIGS. 3A-3E illustrate successive fabrication steps required to build the semiconductor IC inductor shown in FIGS. 2A-2B;

FIG. 4 illustrates another embodiment of the present invention, i.e., a three-dimensional inductor with a trench array core;

FIGS. 5A-5E illustrate successive process steps required to build the semiconductor IC inductor shown in FIG. 4;

FIG. 6 shows a perspective view of yet another embodiment of the present invention, i.e., a "V" shaped three-dimensional IC inductor;

FIG. 7 is a perspective view of the primary and secondary windings of an IC transformer, in accordance with the present invention; and

FIGS. 8A-8D show various representations of a circuit that includes the inductor of the present invention, wherein FIG. 8A is a schematic diagram of a transistor, a capacitor and a resistor integrated with the inventive inductor; FIG. 8B shows the physical layout of the circuit of FIG. 8A; and FIGS. 8C-8D are two cross-section views of the process steps required to build the circuit shown in FIG. 8A.

## DETAILED DESCRIPTION OF THE INVENTION

The embodiment of the invention is discussed hereinafter in conjunction with representative prior art to illustrate the improvements achieved in the invention. In all figures, like elements are given the same reference number.

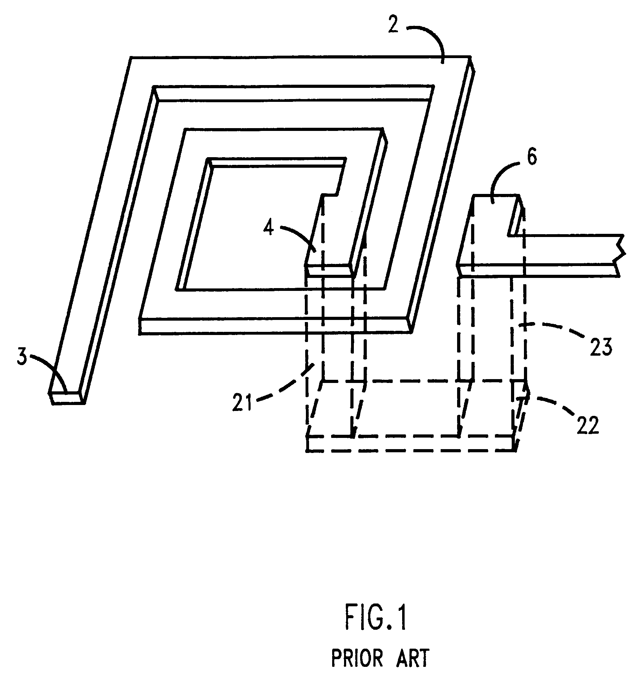

FIG. 1 is a schematic view of a prior art inductor on top of a semiconductor substrate (not shown). The inductor includes a spiral conductor 2 having an outer end 3 and an inner end 4. The end 4 is connected to a lead 6 through a via and lead arrangement. Via 21 penetrates the substrate from the top of the substrate upon which spiral 2 lies to the opposite side of the substrate. An electrical conductor 22 is disposed on the opposite side of the substrate from spiral 2 and in electrical contact with via 21. Similarly, a second conducting via 23 outside the spiral penetrates the substrate. Via 23 is in electrical contact with conductor 22 and with via 6 so that an electrical connection can be made to the inner end 4 from the side of the substrate upon which the spiral is disposed.

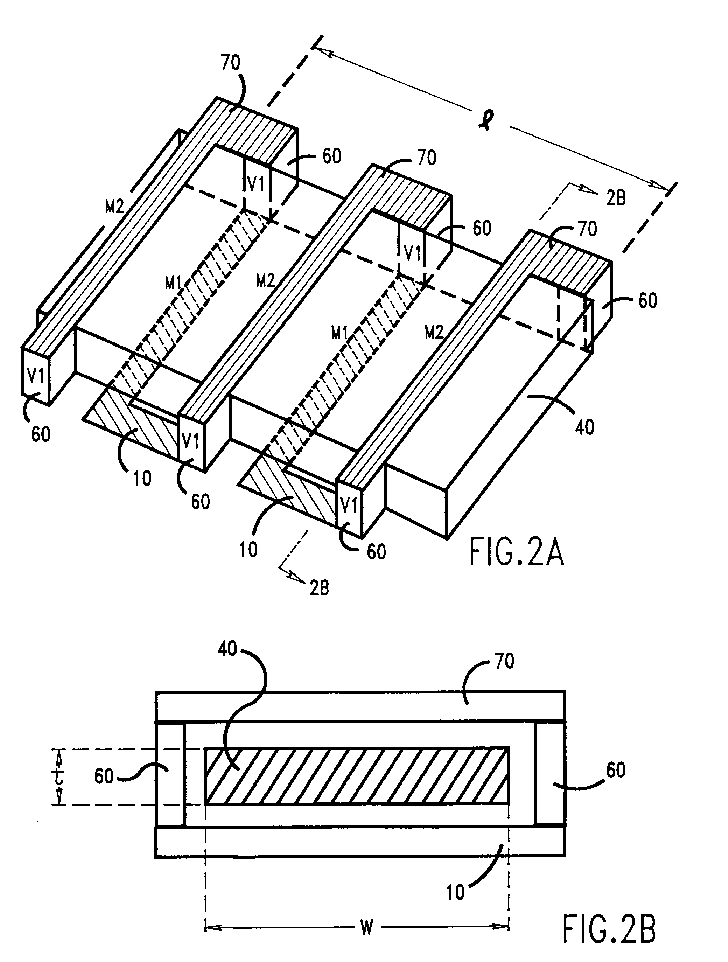

Referring now to FIG. 2A, an "L" shaped inductor is shown having a single core plate 40. Conductive lines 10 are first deposited, each in the shape of an "L". A solid core 40 of magnetic material is then placed to form the next level, bearing a height preferably in the range of less than 1 um to tens of microns. Conductive vias 60 are then formed outside the periphery of the core 40 at the two ends of each "L" of conductive lines 10. The next set of conductive lines 70 is then formed on top of the magnetic core 40 such that the new "L" shaped conductive lines establish contact with the previously formed conductive vias 60, thereby forming the continuous pattern shown in FIG. 2A.

A cross-section of the inductor shown in FIG. 2A is depicted in FIG. 2B, in which the first plurality of planar, conducting lines 10 is separated from the second set of planar, conductive lines 70 by the magnetic core 40. Both sets of planar, conducting lines are electrically connected by conducting vias 60, thereby forming a loop wrapped around the magnetic core 40. Also shown, are the insulating layers 20 and 50 which separate the magnetic core 40, respectively, from conducting lines 10 and 70. FIG. 2B, as shown, is a cross-section of any three-dimensional inductor, regardless of its shape.

The inductor thus formed has an estimated inductance which may be expressed by the following equation:

$$L - (U_0 * U_r * W * t * N ** 2) / \ell,$$

wherein

$U_0 = $ the vacuum permeability = $1.257 \ 10^{-6}$ H/m,
$U_r = $ relative magnetic permeability of the core,
$W = $ width of the magnetic core,
$t = $ thickness of the magnetic core,
$N = $ number of turns of the "metal coils", and
$\ell = $ the length of the magnetic core.

By way of example: for an inductor having $U_r = 1,000$, W = 20 μm, t = 1 μm, $\ell$ = 150 μm and N = 10, an inductance of L = 50.3 nH is thereby obtained.

Similarly, for $U_r = 2,000$, W = 100 μm, t = 1 μm, $\ell$ = 150 μm, and N = 70, the inductance is L = 8.21 μH.

The fabrication process steps illustrated in FIGS.

3A-3E will now be described in more detail.

The substrate 300 material upon which the structure is built can be a bulk Si wafer or a Si-on-Oxide (SOI) wafer or any other material such as glass, quartz plate, GaAs, Ge, SiC, diamond, and the like.

Since the substrate 300 can be either a conductor or a semiconductor, a layer of insulation 301 (FIG. 3A) must first be deposited. This film can be made of oxide, nitride, or polymer, with a thickness that ranges from 200 nm to more than 1 $\mu$m. The deposition method most commonly used encompasses CVD (Chemical Vapor Deposition), spin-off, coating, or sputtering, all of which are conducted at a temperature below 400 °C.

A conductor 10 made of Al, Cu, or any alloy thereof and having a thickness of, preferably, 200 nm to 1 $\mu$m, is deposited as a film on top of the substrate. As previously described, the method of deposition encompasses CVD, evaporation, sputtering, plating and the like, again at a temperature below 400 °C.

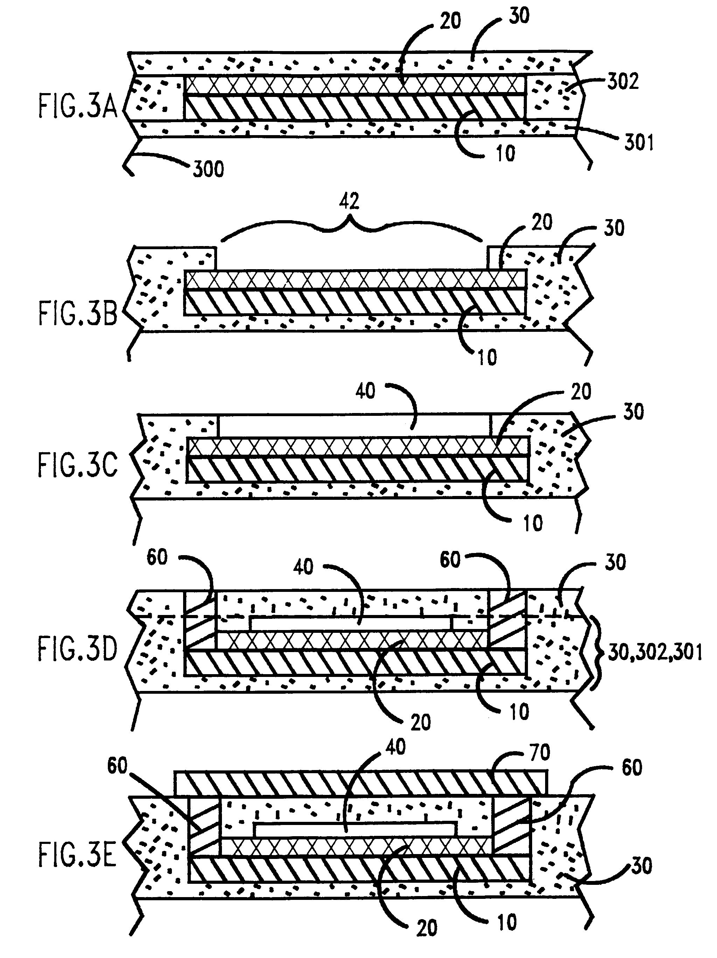

A second layer of insulation 20 of similar material to layer 301 is then deposited. It would be preferable to make it with an RIE (Reactive Ion Etch) having an etch rate different (i.e., slower) than that applied to layer 301, so that it may be used as an etch stop film. Such a material could be alumina ($Al_2O_3$). As may be seen from FIG. 3B, the etch stop film 20 ensures proper functioning during the opening of the dialectric layer to avoid excessive etching. Layer 20 additionally provides the function of insulating the film positioned between the bottom conductor 10 and the core material 40. Next, the conductor 10 and the insulating layer 20 are patterned. Again, RIE can be advantageously used to etch both films via a suitable lithographic tool.

A third insulator layer 30 of the same material as 301 is then deposited and planarized. This layer fills the depressions and crevasses of layer 302. Planarization can be achieved by etch back, chem-mech polish, thermal reflow, or any combination thereof. The resultant insulator thickness may range from 0.5 $\mu$m to several microns.

Practitioners of the art will readily appreciate that the structure comprised of layers 10 and 20 cannot take the shape depicted in FIG. 3A without several additional steps that include RIE processing so as to restrict conductor layers 10 and 20 to conform to the shapes shown in FIGS. 2A-2B.

After resist patterning, area 42 is etched opened in a plasma etch with a stop at layer 20, maintaining an etch rate ratio of layer 30 to layer 20 to approximately 20:1. This region 42 is ultimately filled with permalloy or ferromagnetic material to form a core plate. It is important to note that it is possible to etch and stop at layer 20 to keep the core material at a constant distance from the bottom conductors.

Referring now to FIG. 3C, a layer of core material 40 is deposited (and subsequently planarized) on top of layer 20 such that it fills all open areas 42. The core material is preferably deposited at a temperature ranging from 100 °C to 400 °C, which is well suited for metal conductors having a low melting point. An example of such material is a $Fe_xNi_{80-x}Si_5$ amorphous film. It is highly desirable to overfill all the openings to subsequently polish any excess material. After completing the polishing operation, the core material 40 is formed as a plate or as an array of parallel lines, as will be described hereinafter.

A layer of dielectric film 50 is then deposited to cover the core material, preferably with the same material used for 30. Vias are patterned, etched open until they reach the bottom conductive film 10, and filled with conductive material. The diameter of the vias is dependent on the size of the bottom wires, which can range from sub-micron dimensions to several microns. Preferably, the material used for filling the vias is TiN, W, Al, Cu, and the like. The filling process is then completed by planarizing the surface, using conventional methods. The resultant structure is shown in FIG. 3D.

Referring now to FIG. 3E, conductor material 70 is deposited and patterned so as to form a coil with conducting vias 60 and layer 10 around core 40. As in the previous process step, the material can be Al, Cu, W, alloys or doped amorphous Si. It will be appreciated that, with appropriate patterning of the conductive and core layers, the process described above can be used to form torroidal coils, for example, the "L" shaped coil shown in FIG. 2A.

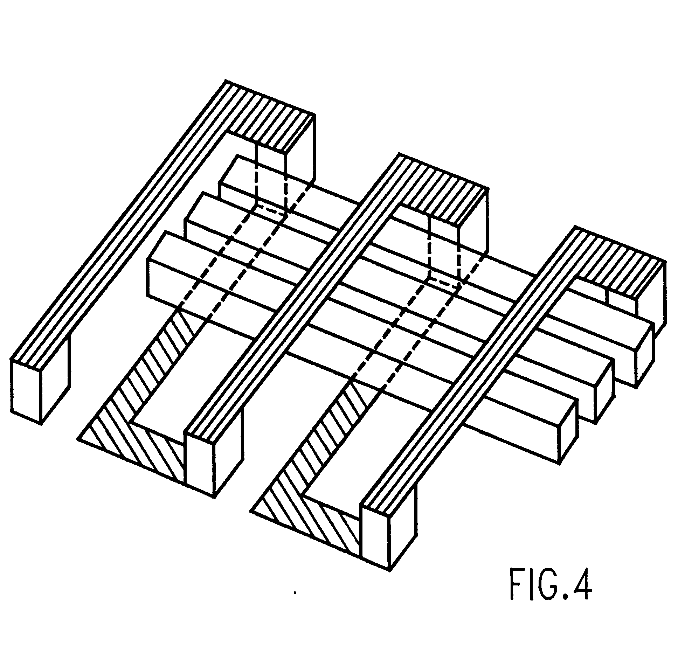

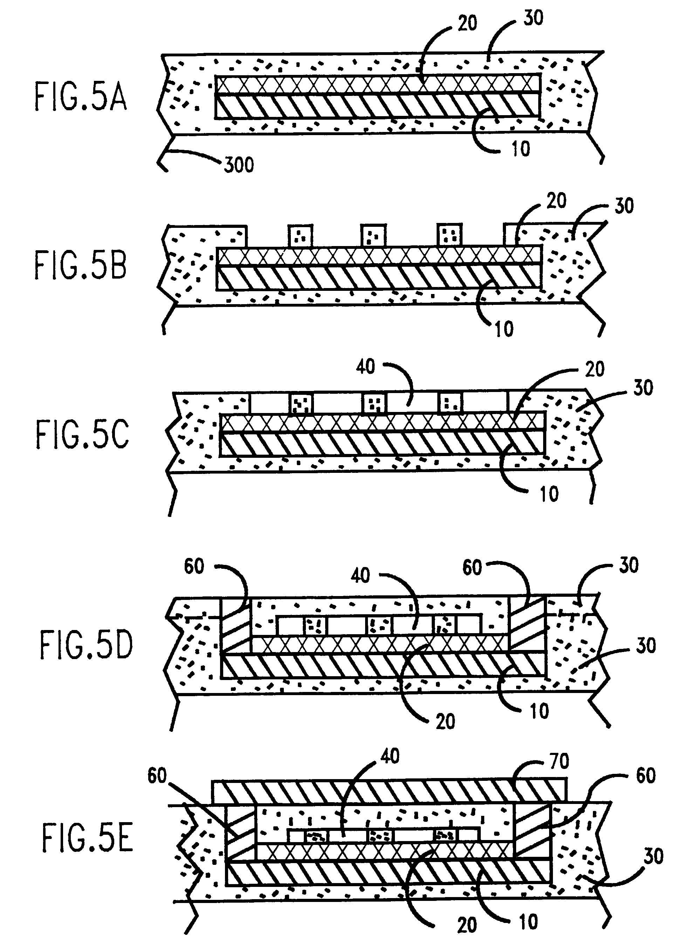

Shown in FIG. 4, is an "L" shaped inductor having a trench array as its magnetic core. A trench array is understood to be a set of parallel stripes of ferromagnetic material separated from each other by insulating material. The manufacturing process steps for a trench array inductor, as illustrated in FIGS. 5A-5E exactly correspond to the process steps just described for the solid core inductor shown in FIGS. 3A-3E. These include: the deposition and patterning of a conductive layer 10 on top of the insulated substrate 300, the formation of insulating layers 20 and 30, followed by planarization, and the formation of open area 42, wherein ferromagnetic material is to be deposited. The sole exception corresponds to the step shown in FIG. 5B, wherein an array of trenches is formed rather than the previous single core plate. Again, the steps following the filling of open area 42 with core material, namely, depositing an insulating layer 50 (FIG. 5C), forming conducting vias 60 (FIG. 5D), and depositing and patterning the second conductive layer 70 (FIG. 5E) are similar to the steps previously explained for the solid core in FIG. 3. A distinct advantage of using an array of trenches is ease of processing, particularly since such a design does not require filling a large opening while maintaining good planarity.

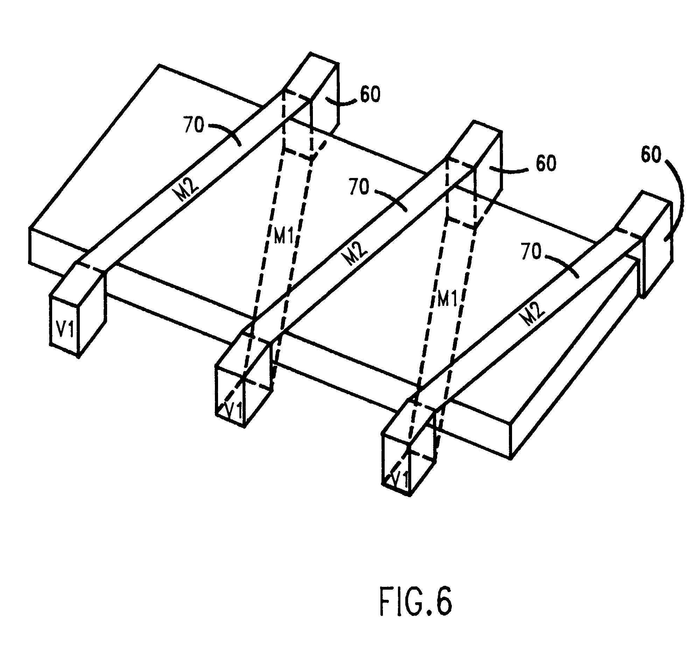

In yet another embodiment of the present invention shown in FIG. 6, a "V" shaped inductor with a solid core plate is illustrated, wherein the coils rather than being perpendicular to each other take the shape of a "V". It is evident that for such a "V" structure, a trench core array of the type shown in FIG. 4, could have been used with equal success. Practitioners of the art will readily appreciate that other "toroidal" shapes, that include zigzags and the like, may be used with equal success.

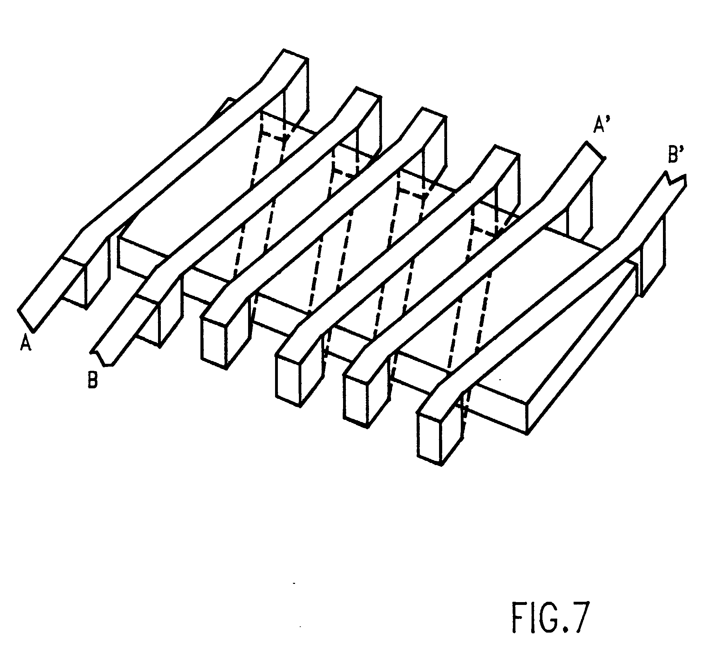

FIGS. 7 shows a perspective view of a transformer in a monolithic IC which is fabricated using the same techniques described for the three-dimensional inductor. Shown are two coils separated by an insulating film but intertwined around the same ferromagnetic core. The coils can take either the aforementioned "L" shape or "V" shape of the inductor. This structure greatly increases the mutual coupling between the windings and makes an efficient on-chip transformer which can find wide application in micro-machining structures, such as micro-motors and micro-generators. Shown in FIG. 7 are the primary winding (identified as A-A') and the secondary coil, (as B-B'). If required, more than two coils around the same core may be used.

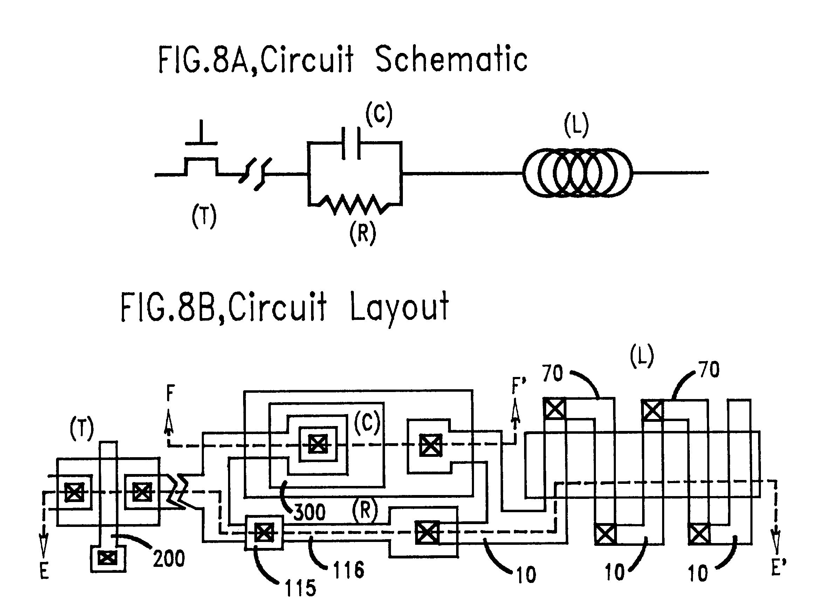

Referring now to FIGS. 8A-8D, a circuit is shown that integrates the tree-dimensional inductor with other active and passive IC components, such as a transistor T, a capacitor C and a resistor R.

FIG. 8A is a schematic diagram of a circuit that includes the three-dimensional inductor. FIG. 8B illustrates the physical layout corresponding to the circuit shown in FIG. 8A.

Transistor T includes a gate 200 which is made with conventional gate material, such as, polysilicon, silicide, or metal. The diffusion area 110 that forms the source and the drain are, likewise, fabricated using conventional process techniques that include ion implantation and annealing.

Resistor (R) 116 shown is an implant resistor which is formed with boron or any other such ion implantation material. Practitioners of the art will fully appreciate that other acceptable materials may be used for making resistors, e.g., implanted conductors, insulators, or semiconductor wires. Also shown are the contacts and interconnects 115 for the resistor, which are made of any metal, such as doped polysilicon, silicide, and the like.

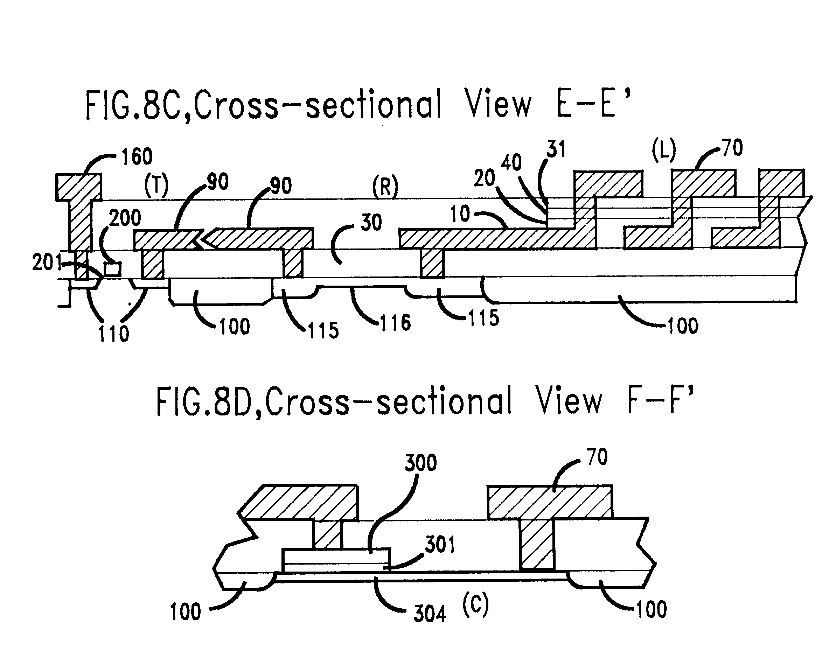

Capacitor C is shown having a lower plate 304 made by diffusion, an upper plate 300 made by gate polysilicon. The capacitor dielectric (shown in more detail in FIG. 8D) can be made of the same gate oxide previously used for transistor T. A first contact is made to the upper plate 300, while a second contact is made to the lower plate 304, both of which directly contact the metal level.

Finally, the three-dimensional inductor is shown having lower and upper "L" shaped metal coils 10 and 70, respectively, and a sandwiched magnetic core insulated by layers 31, and an etch stopper 20 running through the middle of the coils.

Shown in FIGS. 8C and 8D are two cross-section views of the structure depicted in FIG. 8A, wherein E-E' is a cross-section passing through transistor T, resistor R and the middle of the inductor. This is fully illustrated in FIG. 8C. The second cross-section F-F' crosses only the capacitor C, as shown in FIG. 8D.

Referring to FIG. 8C, the local isolation layers 100 isolates each device from other devices. This can be formed by a conventional shallow trench, local recess oxide, or poly buffered oxide. The transistor has a gate 200, gate dielectric 201, source/drain area 110 and source/ drain contacts. More specifically, one contact from source/drain is made to establish a connection to the first level of metal 90, (also constituting the bottom layer 10 of the inductor) whereas, the other contact from source/ drain is made to connect to the second level metal 160. The resistor diffusion area 115 indicates deeper diffusion at the contact areas to avoid uncertainty of the resistance value caused by poor contact resistivity and other similar problems. Both terminals of the resistor are connected to the first metal 10 through conducting vias 60. The bottom coil of the inductor can be the first level metal and coil can be the second level metal.

FIG. 8D shows the cross-section of a plate capacitor. One example, is to use polysilicon gate 300 and diffusion layer 304 as the upper and lower plate, respectively. The wiring of the capacitor is also shown. Again, in order to further save chip layout area, a trench capacitor, a stack capacitor, or any other high density capacitor can be implemented with equal success.

All embodiments of the present invention herein described have shown an inductor which is fully integrable with other active and passive components that form a monolithic integrated circuit. The novel inductors are integrable not only because they are formed on the same substrate, but because they are formed using conventional IC techniques.

While there has been described and illustrated several embodiments of a three-dimensional inductor in an IC, it will be apparent to those skilled in the art that modifications and variations are possible without deviating from the scope of the invention which shall be limited solely by the appended claims.

**Claims**

1. In a monolithic integrated circuit, an inductor comprising:

   a first plurality of planar conductive lines on a substrate;

   a second plurality of planar conductive lines separated from said first plurality of conductive lines;

   a magnetic core between said first plurality of conductive lines and said second plurality of conductive lines;

   insulating material separating said first plurality of conductive lines and said second plurality of conductive lines from said magnetic core; and

conductive vias extending through said insulating material and spaced from said magnetic core, connecting said first and second plurality of conductive lines, wherein

said first and second plurality of conductive lines and said conductive vias form a contiguous conductive coil about said magnetic core.

2. The inductor as recited in claim 1, wherein said magnetic core is placed horizontally over said substrate.

3. The inductor as recited in claim 1, wherein said magnetic core is selected from a group that includes permalloy and ferromagnetic material.

4. The inductor as recited in claim 1, wherein said magnetic core is made of $Fe_xNi_{80-x}Si_5$.

5. The inductor as recited in claim 1, wherein the inductance of said inductor approximates:

$$L = (U_0 * U_r * W * t * N ** 2) / \ell,$$

wherein

$U_0 =$ the vacuum permeability = $1.257 \ 10^{-6}$ H/m,
$U_r =$ relative magnetic permeability of the core,
$W =$ width of the magnetic core,
$t =$ thickness of the magnetic core,
$N =$ number of turns of the "metal coils", and
$\ell =$ the length of the magnetic core.

6. The inductor as recited in claim 1, wherein said first and second conductive lines each have either an "L" or a "V" shape.

7. The inductor as recited in claim 1, wherein said magnetic core is a solid plate and comprises an array of spaced metallic conductors.

8. The inductor as recited in claim 1, wherein said first and second plurality of conductive lines are selected from a group that consists of Cu, Al, and alloys thereof.

9. The inductor as recited in claim 1, wherein said substrate is selected from a group that consists of Si, GaAs, Ge, SiC and glass.

10. The inductor as recited in claim 1, wherein said insulation is selected from a group that consists of oxide, nitride, and polymer.

11. The inductor as recited in claim 1, further comprising a third and fourth plurality of conductive lines separated from each other by said magnetic core and respectively connected to each other by a second set of conducting vias, thereby forming a second continuous electric path independent and insulated from said first electric path.

12. The inductor as recited in claim 1, further comprising electrical connections to circuit elements, wherein said circuit elements include active and passive elements.

13. In a monolithic integrated circuit, a transformer comprising:

at least two first sets of conductive lines on a substrate;

at least two second sets of conductive lines separated from said at least two first sets of conductive lines;

a magnetic core placed between said first sets of conductive lines and said second sets of conductive lines;

insulating material separating said at least two first sets of conductive lines and said at least two second sets of conductive lines from said magnetic core;

a first plurality of conducting vias extending through said insulating material and spaced from said core, connecting the first of said at least two first sets of conductive lines to the first of said at least two second sets of conductive lines;

a second plurality of conductive vias extending through said insulating material and spaced from said core, connecting the second of said at least two first sets of conductive lines to the second of said at least two second sets of conductive lines, wherein

said first of said at least two first sets and said first of said at least two second sets of conductive lines form, respectively, with said first plurality of conducting vias a first independent contiguous conductive coil about said magnetic core, and

said second of said at least two first sets and said second of said two at least second sets of conductive lines form, respectively, with said second plurality of conducting vias a second independent contiguous conductive coil about said magnetic core,

thereby providing a primary and a secondary winding of the transformer.

14. In a monolithic integrated circuit, a method of fabricating an inductor, comprising the steps of:

  providing a substrate;

  depositing on said substrate a first plurality of conducting lines;

  depositing over said first plurality of conducting lines a magnetic core insulated from said first plurality of conducting lines;

  depositing over said magnetic core a second plurality of conductive lines insulated from said magnetic core; and

  forming conducting vias connecting said first and second plurality of conductive lines through said insulation and spaced from said magnetic core, thereby providing a contiguous conductive coil about said magnetic core.

15. The method of fabricating an inductor as recited in claim 14, further comprising the step of:

  depositing a first insulating layer over said first plurality of conductive lines.

16. The method of fabricating an inductor as recited in claim 14, further comprising the step of:

  depositing a second insulating layer over said magnetic core to provide insulation between said magnetic core and said second plurality of conductive lines.

17. The method of fabricating an inductor as recited in claim 14, wherein the step of forming conducting vias includes placing said vias around the periphery of said magnetic core.

18. The method of fabricating an inductor as recited in claim 14, wherein said magnetic core is placed horizontally over said substrate.

19. The method of fabricating an inductor as recited in claim 14, wherein said steps of depositing said first and said second plurality of conductive lines includes forming conductive lines each having an "L" or a "V" shape.

20. The method of fabricating an inductor as recited in claim 14, wherein said magnetic core is selected from a group that consists of permalloy and ferromagnetic material.

21. The method of fabricating an inductor as recited in claim 14, wherein said magnetic core is made of $Fe_xNi_{80-x}Si_5$.

22. The method of fabricating an inductor as recited in claim 14, wherein said magnetic core forms a solid plate and comprises an array of metallic conductors.

23. The method of fabricating an inductor as recited in claim 14, further comprising forming electrical connections to circuit elements, wherein said circuit elements include active and passive elements.

FIG.1

PRIOR ART

FIG.2A

FIG.2B

FIG.3A

FIG.3B

FIG.3C

FIG.3D

FIG.3E

FIG.4

FIG.5A

FIG.5B

FIG.5C

FIG.5D

FIG.5E

FIG.6

FIG.7

# FIG.8A,Circuit Schematic

(C)

(L)

(T)

(R)

# FIG.8B,Circuit Layout

(L)

70

70

F

F'

(C)

(T)

300

(R)

200

115

116

10

10

10

E

E'

EP 0 725 407 A1

# FIG.8C,Cross-sectional View E-E'

# FIG.8D,Cross-sectional View F-F'

EP 0 725 407 A1

**European Patent Office**

# EUROPEAN SEARCH REPORT

Application Number

EP 96 48 0007

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-5 070 317 (BHAGAT)<br><br>* column 6, line 3 - column 11, line 41; figures 1-17B * | 1-3,5,6,<br>8-18,20,<br>23 | H01F17/00 |
| X | US-A-3 881 244 (KENDALL DON LESLIE) 6 May 1975<br>* the whole document * | 1,2,5,6,<br>9,10 | |
| A | PATENT ABSTRACTS OF JAPAN<br>vol. 9, no. 298 (E-361), 26 November 1985<br>& JP-A-60 138954 (TOSHIBA), 23 July 1985,<br>* abstract * | 1,6,8,9,<br>13-17,19 | |
| A | IEEE TRANSLATION JOURNAL ON MAGNETICS IN JAPAN,<br>vol. 7, no. 7, 1 July 1992,<br>pages 514-518, XP000563833<br>SHIRAKAWA K ET AL: "STRUCTURE OF MAGNETIC CORE IN THE THIN FILM INDUCTOR"<br>* page 514, right-hand column, line 24 - page 515, right-hand column, line 12; figures 2,3 * | 7,22 | |
| A | US-A-4 071 378 (ANTHONY) 31 January 1978 | | TECHNICAL FIELDS SEARCHED (Int.Cl.6)<br><br>H01F |
| A<br><br>D,A | EP-A-0 413 348 (MITSUBISHI ELECTRIC CORP) 20 February 1991<br>& US-A-5 095 357<br>----- | | |

The present search report has been drawn up for all claims

| Place of search | Date of completion of the search | Examiner |
|---|---|---|
| THE HAGUE | 9 May 1996 | Bijn, E |

EPO FORM 1503 03.82 (P04C01)